# EUROPEAN PATENT APPLICATION

(11) **EP 4 503 865 A1**
(43) Date of publication of application: **05.02.2025**
(21) Application number: 23780320.0
(22) Date of filing: 27.03.2023
(51) Int. Cl.: H05K 1/02, H01L 23/12, H05K 3/46

(54) **WIRING BOARD AND MOUNTING STRUCTURE**

(30) Priority: 31.03.2022 JP 2022060160
(71) Applicant: Kyocera Corporation, Kyoto-shi, Kyoto 612-8501 (JP)
(72) Inventor: KAWASE, Aki, Kyoto-shi, Kyoto 612-8501 (JP); SHIROSHITA, Makoto, Kyoto-shi, Kyoto 612-8501 (JP)
(74) Representative: Viering, Jentschura & Partner mbB Patent- und Rechtsanwälte
(86) International application number: PCT/JP2023/012150
(87) International publication number: WO 2023/190310

(57) **Abstract**

A wiring board according to the present disclosure includes an insulating layer, a conductive layer including a signal conductor, a ground conductor, and a power supply conductor, a plurality of via hole conductors, and a via hole conductor connecting portion. The part of the signal conductor includes a first wiring group having a plurality of wiring lines extending in a region between a first connecting portion and a second connecting portion, and a second wiring group having a plurality of wiring lines extending in a region between the second connecting portion and a third connecting portion. The first wiring group includes a first portion extending from a region between the second connecting portion and the fifth connecting portion to a region between the fifth connecting portion and the sixth connecting portion, and a second portion extending to a region between the fourth connecting portion and the fifth connecting portion. The second wiring group includes a third portion extending in a region between the fifth connecting portion and the sixth connecting portion, and a fourth portion extending in a region between the third connecting portion and the sixth connecting portion.

## Description

### TECHNICAL FIELD

The present invention relates to a wiring board and a mounting structure.

### BACKGROUND OF INVENTION

In a conventional wiring board as described in Patent Document 1, a signal conductor for transmitting an electric signal between an electronic component and the wiring board is connected to a signal pad among pads for electrically connecting the electronic component and the wiring board via a signal via hole conductor located immediately below the signal pad.

In such a conventional wiring board, a signal conductor is generally drawn from the inside of the board to the outside of the board, and is connected to a pad located inside the board and a pad located outside the board. However, among the pads located on the inside of the board, for example, with respect to the pads located at the corners of the element to be mounted, the signal conductors to be drawn are dense and overlap each other, and all the signal conductors cannot be drawn. In order to draw out all the signal conductors, it is necessary to draw out a part of the signal conductors after lowering them to a lower layer through via conductors. As a result, the number of layers of the wiring board is increased, the inductance of the signal conductor is increased, and the transmission characteristics of the signal may be deteriorated.

### CITATION LIST

### PATENT LITERATURE

Patent Document 1: JP H10-335532 A

### SUMMARY

### SOLUTION TO PROBLEM

A wiring board according to the present disclosure includes: an insulating layer including a first surface and a second surface opposite to the first surface; a conductive layer located on the first surface and including a plurality of signal conductors, a ground conductor, and a power supply conductor; a plurality of via hole conductors penetrating through the insulating layer and located from the first surface to the second surface; and a via hole conductor connecting portion located on the first surface and configured to connect a part of the plurality of via hole conductors to the ground conductor and/or the power supply conductor. The plurality of signal conductors are conductors having a long shape and a first end and a second end. the first surface of the insulating layer includes: a first region in which the via hole conductor connecting portion is located; a second region in which the first end of the plurality of signal conductors located in the first region is located; and a third region in which the second end of the plurality of signal conductors located in the first region is located. In a plan view, the first region is located between the second region and the third region, in the first region, the via hole conductor connecting portion is disposed in a lattice pattern in a first direction along a longitudinal direction in which the first end of the plurality of signal conductors in the second region is arranged, and in a second direction intersecting the first direction. A portion of the via hole conductor connecting portion includes: a first connecting portion; a second connecting portion adjacent to the first connecting portion in the first direction; a third connecting portion adjacent to the second connecting portion in the first direction; a fourth connecting portion adjacent to the first connecting portion in the second direction; a fifth connecting portion adjacent to the fourth connecting portion in the first direction; and a sixth connecting portion adjacent to the fifth connecting portion in the first direction. A part of the signal conductors includes: a first wiring group including a plurality of wiring lines extending in a region between the first connecting portion and the second connecting portion; and a second wiring group including a plurality of wiring lines extending in a region between the second connecting portion and the third connecting portion. The first wiring group includes: a first portion extending from a region between the second connecting portion and the fifth connecting portion to a region between the fifth connecting portion and the sixth connecting portion; and a second portion extending in a region between the fourth connecting portion and the fifth connecting portion. The second wiring group includes: a third portion extending in a region between the fifth connecting portion and the sixth connecting portion; and a fourth portion extending in a region between the third connecting portion and the sixth connecting portion.

A mounting structure according to the present disclosure includes the wiring board described above and an electronic component located at a mounting region of the wiring board.

### BRIEF DESCRIPTION OF THE DRAWINGS

FIG. 1 is a plan view illustrating a main portion of a conductive layer located on a first surface of an insulating layer in a wiring board according to an embodiment of the present disclosure.
FIG. 2 is a schematic view illustrating a state in which a conductive layer is layered on a first surface of an insulating layer.
FIG. 3 is an enlarged view for explaining a region X illustrated in FIG. 1.
FIG. 4 is a plan view illustrating a main portion of a conductive layer located on a first surface of an insulating layer in a wiring board according to another embodiment of the present disclosure.
FIG. 5 is a plan view illustrating a main portion of a conductive layer located on a first surface of an insulating layer in a wiring board according to still another embodiment of the present disclosure.
FIG. 6 is a cross-sectional view illustrating a mounting structure according to an embodiment of the present disclosure.

### DESCRIPTION OF EMBODIMENTS

In a conventional wiring board as described in Patent Document 1, a signal conductor is generally drawn from the inside of the board to the outside of the board, and is connected to a pad located on the inside of the board and a pad located on the outside of the board. However, among the pads located on the inside of the board, for example, with respect to the pads located at the corners of the element to be mounted, the signal conductors to be drawn are dense and overlap each other, and all the signal conductors cannot be drawn. In order to draw out all the signal conductors, it is necessary to draw out a part of the signal conductors after lowering them to a lower layer through via conductors. As a result, the number of layers of the wiring board is increased, the inductance of the signal conductor is increased, and the transmission characteristics of the signal may be deteriorated. Therefore, there is a demand for a wiring board in which a signal conductor can be drawn without increasing the number of layers and the inductance of the signal conductor can be reduced.

In the wiring board according to the present disclosure, the signal conductor is drawn without increasing the number of layers, and the inductance of the signal conductor is small. Therefore, in the wiring board according to the present disclosure, the signal waveform is unlikely to be deformed from a rectangular shape. Since the wiring board according to the present disclosure can maintain the signal waveform in a rectangular shape, the quality of the signal waveform is high, and malfunction of the mounted element can be reduced.

The mounting structure according to the present disclosure has a high-quality signal waveform and can reduce malfunctions of electronic components such as mounted elements.

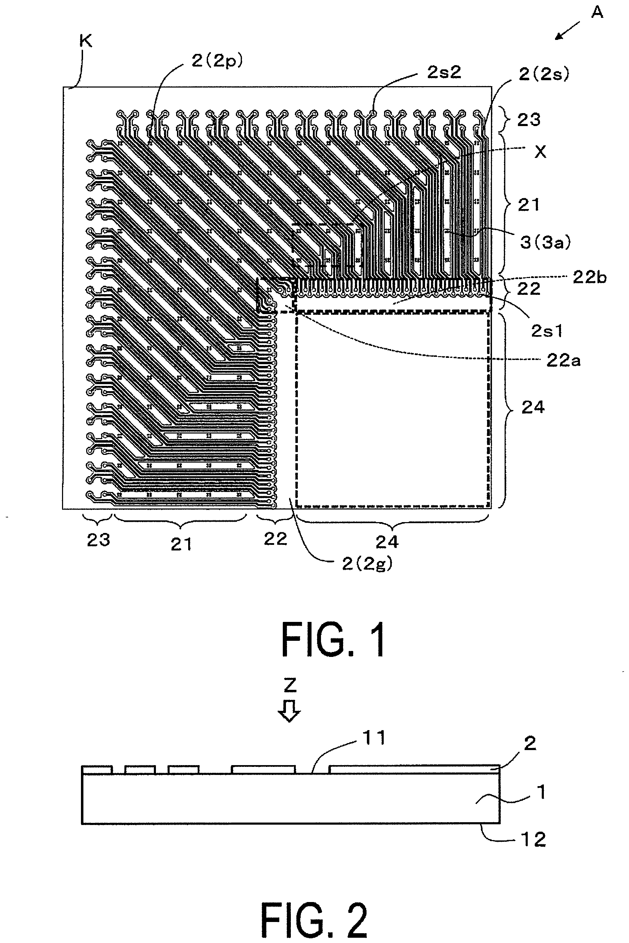

A wiring board according to an embodiment of the present disclosure will be described with reference to FIGs. 1 to 3. FIG. 1 is a plan view illustrating a main portion of a conductive layer located on a first surface of an insulating layer in a wiring board A according to an embodiment of the present disclosure. Specifically, FIG. 1 illustrates one of four equal parts obtained by dividing the wiring board A into four parts so as to include a corner portion of the wiring board A, and in the drawing, the upper left corresponds to the corner portion of the wiring board A, and the lower right corresponds to the central portion of the wiring board A. FIG. 2 is a schematic view illustrating a state where a conductive layer is layered on the first surface of the insulating layer. That is, FIG. 1 is a plan view seen from the direction of the arrow Z in FIG. 2. In FIG. 2, originally provided via hole conductors and structures located on the second surface side (for example, conductive layers and other insulating layers (core insulating layers)) are omitted.

As illustrated in FIG. 2, the wiring board A according to the embodiment includes an insulating layer 1 and a conductive layer 2 located on a first surface 11 of the insulating layer 1. The insulating layer 1 is not particularly limited as long as it is made of an insulating material. Examples of the material having the insulation properties include resins such as an epoxy resin, a bismaleimide-triazine resin, a polyimide resin, and a polyphenylene ether resin. Two or more types of these resins may be mixed and used. The thickness of the insulating layer 1 is not particularly limited. For example, in the case of a package substrate, the thickness is 5 µm or more and 100 µm or less, and in the case of a board substrate, the thickness is 50 µm or more and 300 µm or less.

The insulating layer 1 may contain a reinforcing material. Examples of the reinforcing material include insulation fabric materials such as glass fiber, glass non-woven fabric, aramid non-woven fabric, aramid fiber, and polyester fiber. Two or more types of reinforcing materials may be used in combination. An inorganic insulating filler such as silica, barium sulfate, talc, clay, glass, calcium carbonate, or titanium oxide may be dispersed in the insulating layer 1.

Although not illustrated in FIG. 2, the insulating layer 1 includes a plurality of via hole conductors (via hole conductors 3a illustrated in FIG. 1) that penetrate the insulating layer 1 and are located from the first surface 11 to a second surface 12. The via hole conductors 3a are located in via holes penetrating from the first surface 11 to the second surface 12 of the insulating layer 1. The via hole conductors 3a are made of, for example, metal-plated conductors such as copper-plated conductors. The via hole conductors 3a are connected to the conductive layer 2 located on the first surface 11 and the second surface 12 of the insulating layer 1. The via hole conductors 3a may be located only on the inner walls of the via holes or may be filled in the via holes.

The conductive layer 2 is located on the first surface 11 of the insulating layer 1. As illustrated in FIG. 1, the conductive layer 2 includes a signal conductor 2s, a ground conductor 2g, and a power supply conductor 2p. The thickness of the conductive layer 2 is not particularly limited. For example, in the case of a package substrate, the thickness is 3 µm or more and 30 µm or less, and in the case of a board substrate, the thickness is 10 µm or more and 50 µm or less.

The signal conductor 2s serves to a transmit signal. The signal conductor 2s is adjusted so as to match impedance values as much as possible over the entire wiring board 1. Thus, a loss when a signal is transmitted through the signal conductor 2s can be reduced.

The signal conductor 2s is located in a first region 21 to be described below, and both end portions thereof are located in a region other than the first region 21. That is, both ends (first end 2s1 and second end 2s2) of the signal conductor 2s are located to be separated from each other with the first region 21 interposed therebetween. In the present specification, of both ends of the signal conductor 2s, the end closer to the central portion of the wiring board is referred to as the first end 2s 1, and the end closer to the outside of the wiring board is referred to as the second end 2s2. The first end 2s 1 and the second end 2s2 are connected to lands that are portions of the conductive layer 2 located in a second region 22 and a third region 23 described below. On the first surface 11 of the insulating layer 1, a region where the first end 2s 1 of the signal conductor 2s is located is referred to as a second region, and a region where the second end 2s2 of the signal conductor 2s is located is referred to as a third region.

The ground conductor 2g functions to match the impedance of the signal conductor 2s and to reduce noise mixed into the signal conductor 2s. The power supply conductor 2p functions as a path for supplying a charge. Therefore, it is advantageous to dispose the power supply conductor 2p immediately below and around the mounting region close to the electronic component because the electric resistance is reduced. In FIG. 2, specific positions of the ground conductor 2g and the power supply conductor 2p are merely indicated for convenience. In FIG. 2, the power supply conductor 2p may be located at a position indicating the ground conductor 2g, and the ground conductor 2g may be located at a position indicating the power supply conductor 2p. In the conductive layer 2, the conductors other than the signal conductor 2s are the ground conductor 2g and/or the power supply conductor 2p.

A portion of the via hole conductor 3a is connected to the ground conductor 2g and/or the power supply conductor 2p. As illustrated in FIG. 1, the via hole conductor connecting portion 3, which is a connecting portion between a part of the via hole conductors 3a and the ground conductor 2g and/or the power supply conductor 2p, is disposed in a lattice pattern along the first surface 11. In the first surface 11 of the insulating layer 1, a region where the via hole conductor connecting portion 3 is located is referred to as the first region 21.

In the first region 21, the signal conductor 2s and the via hole conductor connecting portion 3 are located so as not to overlap each other. That is, the signal conductor 2s is extended from the first end 2s1 to the second end 2s2 so as to pass between the via hole conductor connecting portion 3 located in a lattice pattern. A portion of the via hole conductor connecting portion 3 may be surrounded by a plurality of signal conductors 2s. This is advantageous in that the via hole conductor connecting portion 3 can be disposed in a narrow region. Paired wiring lines may be included as the signal conductor 2s. In a portion where the paired wiring lines are used as the signal conductor 2s, it is advantageous that the via hole conductor connecting portion 3 is not interposed between the wiring lines constituting the paired wiring lines from the viewpoint of improving signal characteristics.

In the signal conductor 2s, the pitch of the first end 2s 1 may be smaller than the pitch of the second end 2s2. When the pitch of the first end 2s 1 is smaller than the pitch of the second end 2s2, for example, in a case where a device is mounted in the vicinity of an upper portion of the second region 22 in which the first end 2s1 is disposed, it is advantageous in that it can correspond to a device having a higher density of electrodes.

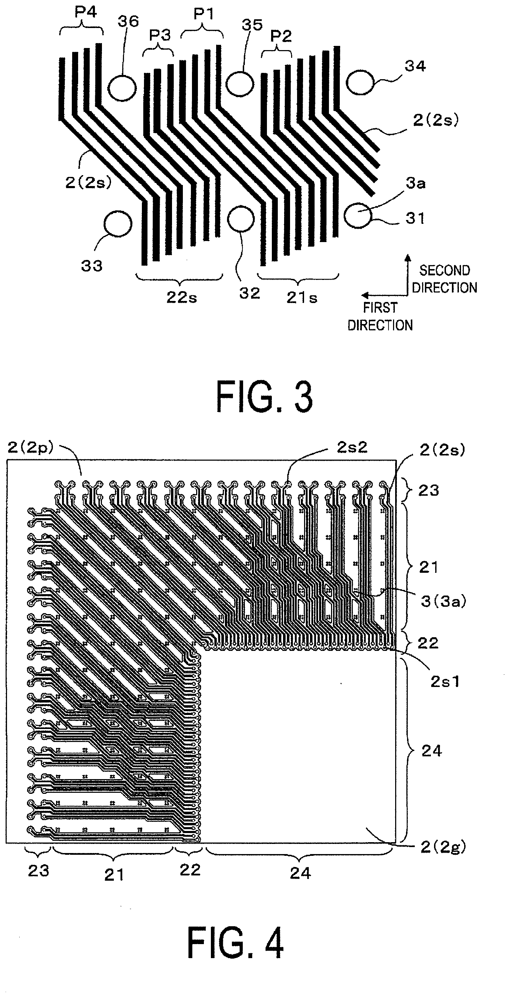

In the wiring board A according to the embodiment, a portion of the via hole conductor connecting portion 3 and a part of the signal conductors 2s have the following structure. As illustrated in FIG. 3, a portion of the via hole conductor connecting portion 3 includes a first connecting portion 31, a second connecting portion 32, a third connecting portion 33, a fourth connecting portion 34, a fifth connecting portion 35, and a sixth connecting portion 36. FIG. 3 is an enlarged explanatory view for explaining a region X illustrated in FIG. 1.

With reference to the first connecting portion 31, the second connecting portion 32 is adjacent to the first connecting portion in the first direction. The third connecting portion 33 is adjacent to the second connecting portion 32 in the first direction. The fourth connecting portion 34 is adjacent to the first connecting portion 31 in the second direction. The fifth connecting portion 35 is adjacent to the fourth connecting portion 34 in the first direction. The sixth connecting portion 36 is adjacent to the fifth connecting portion 35 in the first direction. Three of the first connecting portion 31, the second connecting portion 32, the third connecting portion 33, the fourth connecting portion 34, the fifth connecting portion 35, and the sixth connecting portion 36 are arranged in two stages in the longitudinal direction in which the first end 2s1 of the signal conductor 2s is arranged. The via hole conductor connecting portion 3 closest to the corner of the first surface 11 is the sixth connecting portion 36the first connecting portion 31 is located diagonally to the sixth connecting portion 36, the fourth connecting portion 34 is located to face the first connecting portion 31, the third connecting portion 33 is located to face the sixth connecting portion 36, the second connecting portion 32 is located between the first connecting portion 31 and the third connecting portion 33, and the fifth connecting portion 35 is located to face the second connecting portion 32.

Here, the first direction is a direction along the longitudinal direction in which the first end 2s1 located adjacent to the via hole conductor connecting portion 3 is arranged, and the second direction is a direction crossing the first direction. In other words, a direction along the longitudinal direction of a side portion 22b of the second region 22 described below is the first direction. In the wiring board A according to the present disclosure, in the first region 21 interposed between at least one side portion 22b and the third region 23, the first to sixth connecting portions 31, 32, 33, 34, 35, and 36 are disposed in the above-described arrangement in the first direction and the second direction. Although FIG. 3 illustrates an example in which the first direction and the second direction are orthogonal to each other, the angle between the first direction and the second direction may be, for example, 45 ° or 60 °.

As illustrated in FIG. 3, a part of the signal conductors 2s is constituted by a first wiring group 21s and a second wiring group 22s. The first wiring group 21s includes a plurality of wiring lines (signal conductors 2s) located between the first connecting portion 31 and the second connecting portion 32. The second wiring group 22s includes a plurality of wiring lines (signal conductors 2s) located between the second connecting portion 32 and the third connecting portion 33.

As illustrated in FIG. 3, a part of the signal conductors 2s constituting the first wiring group 21s include a first portion P1 extending in a region between the second connecting portion 32 and the fifth connecting portion 35 and a region between the fifth connecting portion 35 and the sixth connecting portion 36, and a second portion P2 extending in a region between the fourth connecting portion 34 and the fifth connecting portion 35.

As illustrated in FIG. 3, a part of the signal conductors 2s constituting the second wiring group 22s include a third portion P3 extending in a region between the fifth connecting portion 35 and the sixth connecting portion 36, and a fourth portion P4 extending in a region between the third connecting portion 33 and the sixth connecting portion 36.

In the first surface 11 of the insulating layer 1, as illustrated in FIG. 1, a quadrangular region overlapping a region in which an electronic component such as an element is mounted in a plane perspective is defined as a fourth region 24. The second region 22 is a region sandwiched between the first region 21 and the fourth region 24. The second region 22 includes a corner portion 22a located adjacent to a corner of the fourth region 24 and/or the side portion 22b located along a side of the fourth region 24. The corner of the corner portion 22a of the second region 22 is a region opposed to the corner of the fourth region 24, and is appropriately determined according to the size of the wiring board and the size of the fourth region 24. Examples of the element include semiconductor elements such as a semiconductor integrated circuit element and an optoelectronic element.

Among the lands located in the second region 22 of the wiring board A, the signal conductor 2s is preferentially drawn from the lands located in the corner portion 22a in the direction of 45 ° toward the corner K of the wiring board A, and is connected to the lands located in the third region 23 near the corner K of the wiring board A.

Among the lands located in the second region 22 of the wiring board A, the signal conductor 2s is drawn from the lands located in the side portion 22b toward the outer edge of the wiring board A, and is connected to the lands located in the third region 23 near the outer edge of the wiring board. The signal conductor 2s having the first end 2s1 in the side portion 22b include the first wiring group 21s and the second wiring group 22s having the above-described structure. In the first region 21, the signal conductor 2s having the first end 2s1 at the side portion 22b is preferably located in a straight line so as not to overlap the via hole conductor connecting portion 3.

In this manner, the signal conductor 2s is linearly drawn preferentially from the corner portion 22a of the second region 22 toward the corner K of the wiring board A, and the signal conductor 2s including the first wiring group 21s and the second wiring group 22s having the above-described structure is drawn from the side portion 22b of the second region 22, whereby the signal conductor 2s does not overlap each other in a portion where the signal conductors 2s are dense. As illustrated in FIG. 1, in the case where the region along the second direction is longer as the signal conductor 2s is located closer to the center side of the wiring board A, it is easy to dispose the ground conductor 2g between the signal conductors 2s, for example, at equal intervals, which is advantageous in terms of electrical characteristics.

In the signal conductors 2s (first signal conductor) in which the first end 2s1 is located at the corner portion 22a of the second region 22, the number of turning points at which an extending direction is changed may be smaller than the number of turning points at which the extending direction is changed in the signal conductor 2s (second signal conductor) in which the first end 2s1 is located at the side portion 22b of the second region 22. With such a configuration, the length of the signal conductor 2s, which is disposed between the corner portion 22a and the corner of the first surface 11 and in which the signal length tends to be long, can be reduced, and the transmission characteristics can be improved.

In the first region 21, the portion including the first wiring group 21s and the second wiring group 22s and the portion including the first connecting portion 31, the second connecting portion 32, the third connecting portion 33, the fourth connecting portion 34, the fifth connecting portion 35, and the sixth connecting portion 36 have the above-described specific structure, whereby all of the signal conductors 2s present in the same conductive layer 2 can be drawn without increasing the number of layers. Since the number of layers of the signal conductors 2s constituting the first wiring group 21s and the second wiring group 22s does not increase, the inductance of the signal conductors 2s can be reduced. Therefore, in the wiring board according to the embodiment, since the signal waveform is easily maintained, the quality of the signal waveform is high, and the malfunction of the mounted element can be reduced.

The wiring board of the present disclosure is not limited to the wiring board according to the above-described embodiment. In the wiring board according to the embodiment, the portion having the specific structure as described above is minimized. However, as illustrated in FIG. 4, the wiring board of the present disclosure may include a large number of portions having the specific structure as described above. With such a structure, for example, an effect of reducing a difference in transmission time of a signal by equalizing signal line lengths between the plurality of signal conductors 2s can be expected. FIG. 4 is a plan view illustrating a main portion of a conductive layer located on a first surface of an insulating layer in a wiring board according to another embodiment of the present disclosure.

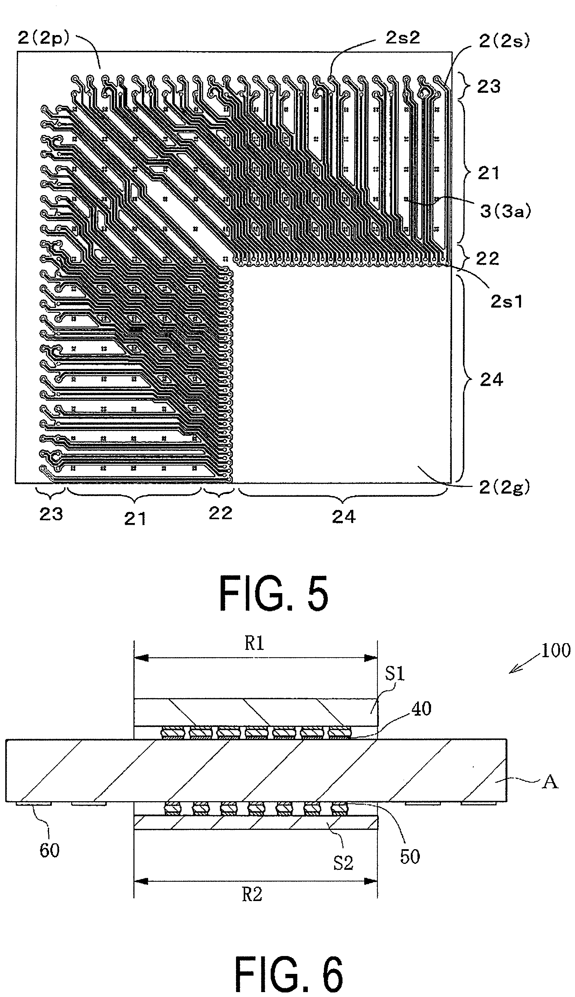

The portion having the specific structure as described above may be further increased. As illustrated in FIG. 5, for example, a specific structure may be regularly provided such that the number of specific structures increases toward the corner of the wiring board. With such a structure, for example, an effect of improving the power supply efficiency by increasing the arrangement area of the power supply conductor or the ground conductor in the vicinity of the center of the wiring board can be expected. FIG. 5 is a plan view illustrating a main portion of a conductive layer located on a first surface of an insulating layer in a wiring board according to still another embodiment of the present disclosure.

A mounting structure 100 according to an embodiment in which a first electronic component S1 and a second electronic component S2 are mounted on the above-described wiring board A will be described with reference to FIG. 6. The wiring board A has, for example, a first mounting region R1 on the upper surface and a second mounting region R2 on the lower surface. A plurality of first electrodes 40 are located in the first mounting region R1. A plurality of second electrodes 50 are located in the second mounting region R2. A plurality of third electrodes 60 connected to, for example, an external circuit substrate are located in a region other than the second mounting region R2 on the lower surface of the wiring board A.

Examples of the first electronic component S1 include semiconductor devices such as an application specific integrated circuit (ASIC), a semiconductor IC device, and an optoelectronic device. The first electronic component S1 is connected to the first electrode 40 by soldering. The second electronic component S2 is, for example, a memory. The second electronic component S2 is connected to the second electrode 50 by a solder.

In the mounting structure 100 according to the present disclosure, for example, the first electronic component S1 and the second electronic component S2 are mounted on the wiring board A having the above-described structure. As a result, for example, the qualities of signal waveforms between the first electronic component S1 and the second electronic component S2 and between the first electronic component S1 and the external circuit substrate are high, and malfunctions of elements such as an ASIC to be mounted can be reduced. In the mounting structure 100 of the present disclosure, the electronic components are mounted on the upper surface and the lower surface of the wiring board A one by one. However, a plurality of electronic components may be mounted.

For example, in a plane perspective, the outer edge of the first mounting region R1 and/or the second mounting region R2 may be located along the above-described first direction (the longitudinal direction in which the first end 2s1 located adjacent to the via hole conductor connecting portion 3 is arranged). This makes it easy to reduce the lengths of wiring line connections between the electronic components mounted on the wiring board A and the first end 2s 1 of the signal conductor 2s, and it is advantageous in improving the quality of the signal waveform.

### REFERENCE SIGNS

1 Insulating layer
11 First surface
12 Second surface
2 Conductive layer
2s Signal conductor
2s1 First end
2s2 Second end
2g Ground conductor
2p Power supply conductor
21 First region
22 Second region
23 Third region
24 Fourth region
21s First wiring group
22s Second wiring group
3 Via hole conductor connecting portion
3a Via hole conductor
31 First connecting portion
32 Second connecting portion
33 Third connecting portion
34 Fourth connecting portion
35 Fifth connecting portion
36 Sixth connecting portion
P1 First portion
P2 Second portion
P3 Third portion
P4 Fourth portion

## Claims

1. A wiring board comprising:
an insulating layer comprising a first surface and a second surface opposite to the first surface;
a conductive layer located on the first surface and comprising a plurality of signal conductors, a ground conductor, and a power supply conductor;
a plurality of via hole conductors penetrating through the insulating layer and located from the first surface to the second surface; and
a via hole conductor connecting portion located on the first surface and configured to connect a part of the plurality of via hole conductors to the ground conductor and/or the power supply conductor, wherein
the plurality of signal conductors are conductors having a long shape and comprising a first end and a second end,
the first surface of the insulating layer comprises:
a first region in which the via hole conductor connecting portion is located;
a second region in which the first end of the plurality of signal conductors located in the first region is located; and
a third region in which the second end of the plurality of signal conductors located in the first region is located,
in a plan view,
the first region is located between the second region and the third region,
in the first region, the via hole conductor connecting portion is disposed in a lattice pattern in a first direction along a longitudinal direction in which the first end of the plurality of signal conductors in the second region is arranged, and in a second direction intersecting the first direction,
a portion of the via hole conductor connecting portion comprises:
a first connecting portion;
a second connecting portion adjacent to the first connecting portion in the first direction;
a third connecting portion adjacent to the second connecting portion in the first direction;
a fourth connecting portion adjacent to the first connecting portion in the second direction;
a fifth connecting portion adjacent to the fourth connecting portion in the first direction; and
a sixth connecting portion adjacent to the fifth connecting portion in the first direction,
a part of the signal conductors comprises:
a first wiring group comprising a plurality of wiring lines extending in a region between the first connecting portion and the second connecting portion; and
a second wiring group comprising a plurality of wiring lines extending in a region between the second connecting portion and the third connecting portion,
the first wiring group comprises:
a first portion extending from a region between the second connecting portion and the fifth connecting portion to a region between the fifth connecting portion and the sixth connecting portion; and
a second portion extending in a region between the fourth connecting portion and the fifth connecting portion, and
the second wiring group comprises:
a third portion extending in a region between the fifth connecting portion and the sixth connecting portion; and
a fourth portion extending in a region between the third connecting portion and the sixth connecting portion.

2. The wiring board according to claim 1, wherein
the first direction and the second direction are orthogonal to each other.

3. The wiring board according to claim 1 or 2, wherein
the plurality of signal conductors comprise a plurality of paired wiring lines, and the via hole conductor connecting portion is not interposed between wiring lines constituting the paired wiring lines.

4. The wiring board according to any one of claims 1 to 3, wherein
in the plurality of signal conductors, a pitch between the signal conductors at the first end is smaller than a pitch between the signal conductors at the second end.

5. The wiring board according to any one of claims 1 to 4, wherein
the first surface of the insulating layer comprises a quadrangular fourth region overlapping the mounting region in a perspective plan view, and the second region comprises a corner portion located at a corner of the fourth region and/or a side portion located along a side of the fourth region.

6. The wiring board according to claim 5, wherein
the plurality of signal conductors comprise a first signal conductor comprising the first end located at the corner portion and a second signal conductor comprising the first end located at the side portion, and a number of turning points at which an extending direction of the first signal conductor is changed is smaller than a number of turning points at which the extending direction of the second signal conductor is changed.

7. A mounting structure comprising:
the wiring board according to any one of claims 1 to 6; and
an electronic component located in a mounting region of the wiring board.

8. The mounting structure according to claim 7, wherein
an outer edge of the mounting region is located along the first direction in a plane perspective.
